# EUROPEAN PATENT SPECIFICATION

(11) **EP 2 699 072 B1**
(45) Date of publication and mention of the grant of the patent: **29.03.2017**
(21) Application number: 13180108.6
(22) Date of filing: 12.08.2013
(51) Int. Cl.: H05K 13/04

(54) **Cassette tape feeder for positioning SMD electronic elements**
Kassettenbandzuführung zur Positionierung elektronischer SMD-Elemente
Dispositif d'alimentation de bande de cassette pour le positionnement des éléments électroniques SMD

(30) Priority: 14.08.2012 PL 40038512
(43) Date of publication of application: 19.02.2014
(73) Proprietor: Wladyslaw Wlodarczyk IGLOO, 32-720 Nowy Wisnicz (PL)
(72) Inventor: Wlodarczyk, Milosz, 32-700 Bochnia (PL)
(74) Representative: Hudy, Ludwik

(56) References cited:
- EP-A1- 1 381 265
- WO-A1-2012/049799
- US-A1- 2008 263 856
- US-B1- 6 379 098

## Description

The invention relates to a cassette tape feeder for positioning SMD (Surface Mount Device) electronic elements or components used to supply SMD elements or components from tapes in assembly automatons and semi-automatons using the SMT technology, provided in combination with a set of carrier tape and cover tape guides, according to the preamble of claim 1. The cassette tape can comprise a body, a drive for feeding a carrier tape with a toothed wheel engaging with holes of the carrier tape and seated on the body, a drive for removing a cover tape with a reel for reeling the cover tape, a carrier tape and cover tape reel rotationally seated on the body and a carrier tape and cover tape guide located above a toothed wheel of a drive for displacement of the carrier tape engaging with the holes of the carrier tape. The present cassette tape feeder most frequently cooperates with a head with a suction nozzle, which picks up an electronic component from the feeder and transports it to its proper place on a printed circuit board (PCB).

Every year the number of manufactured electronic devices increases, and most of their subassemblies is installed on printed circuit boards. At the moment, subassemblies are installed on assembly automatons and semi-automatons using the SMT technology, and application of cassette tape feeders cooperating with the heads for positioning electronic components significantly increases the output of the mentioned automatons and semi-automatons.

Application US 5,725,140 titled "Tape feeder for a surface mount placement system" discloses a device for transporting a carrier tape with pockets in which electronic components are located. The supply system of this device cooperates with a cam and a lever providing accuracy of electronic components supply.

However, application US 7,380,581 titled "Tape feeder and tape feeding and recovering module thereof" discloses a tape feeder with two modules. One of them is a module displacing a tape with electronic components, and the other is a module recovering a top tape, which covers the electronic components. Both modules cooperate with each other and due to this fact, this solution is very complicated.

Moreover, from application US 7,243,828 B2 entitled "Tape feeder for component mounter and method of automatically setting initial tape position to the same" a conveyor belt is known, which supplies a tape on which components are placed, separates a cover tape from the tape in such a way that the components can be picked up by the device assembling the components.

Patent Specification US 6,379,098 titled "Chip feeder for chip mounter" teaches a chip feeder for the chip mounter which includes a tape feeding mechanism for feeding a carrier tape that includes a rotating connection member for connecting the carrier tape, a first motor for driving the rotating connection member and a first transmission mechanism for transmitting drive power to the rotating connection member, and a cover peeling mechanism for peeling a top cover tape from the carrier tape that includes a peeling reel for winding the top cover tape, a second motor for driving the peeling reel and a second transmission mechanism for transmitting drive power to the peeling reel. The first and second motors are outer rotor motors each of which includes a cylindrical stator fixed to a base having exciter coils and pole pieces, and a cylindrical rotor arranged around the stator with a gap. The first and second transmission mechanisms are engaged with outer surfaces of the rotors

Application US 2008/0263856 titled "Tape feeder for chip mounter" teaches a tape feeder for a chip mounter is provided. The tape feeder includes a frame, a first link, a second link, and a middle link. A tape is fed along the frame. The first link includes a guide unit guiding the tape and a first end rotatably connected to the frame. The first link is capable of being rotated between a closed position in which the guide unit couples with the frame to guide the tape and an open position in which the guide unit is placed away from the frame. The second link is rotatably connected to the frame and includes a first end supported relative to the frame. The middle link includes a first end rotatably connected to a second end of the first link and a second end rotatably connected to a second end of the second link.

Furthermore, International Patent Application WO 2012/049799 A1 titled "Tape feeder and method of mounting tape onto tape feeder" teaches a tape feeder with a guide part that guides a carrier tape and is detachably attached to a main body. The guide part includes a lower member guiding the carrier tape and attached to and detached from the main body, an upper member pressing down the carrier tape from above, a tape introduction part guiding the carrier tape into the upper member at an upstream side thereof in a tape feed direction, a confirmation opening part disposed in the upper member for visually confirming that the carrier tape arrives at a pin engagement range, an open/close mechanism opening and closing the upper member with respect to the lower member and a positioning mechanism fitting a positioning pin into a feed hole of the carrier tape in the guide part, thereby positioning the carrier tape relative to the guide part in the tape feed direction.

In addition, European Patent Application EP 1 381 265 titled "Tape guide, magazine and system at a component mounting machine" teaches a tape guide for guiding a carrier tape in a component mounting machine. The component mounting machine has a tape magazine for receiving at least one such tape guide, a system comprising a component mounting machine and at least one such tape guide and a system that comprises a component mounting machine, at least one such tape guide, and a tape magazine. The carrier tape carries components positioned in sequence on the carrier tape and covered by a cover tape. The tape guide comprises means for guiding the carrier tape and for exposing the components at a picking position, and is arranged for ready and quick attachment and detachment of the tape guide to and from the component mounting machine or the magazine. The tape guide further lacks feeding means for feeding the carrier tape towards a picking position in the machine, which feeding means are provided in the magazine or in the component mounting machine.

The purpose of the invention is to create a cassette tape feeder that improves accuracy and reliability of the tape feed with SMD components and allows using of all tape width standards.

According to the invention a task is solved by the features of claim 1. Deliberate and preferred embodiments are included in the dependent claims and in a description of figures.

In a case of a cassette tape feeder for positioning SMD electronic components placed on a carrier tape with holes and covered with a cover tape, according to the invention is provided a drive for feeding a carrier tape with a toothed wheel engaging with holes of the carrier tape and seated on the body, a drive for removing the cover tape with a reel for reeling the cover tape, a carrier tape and cover tape reel rotationally seated in relation to the body and a carrier tape and cover tape guide located above a toothed wheel of a drive for displacement of the carrier tape engaging with the holes of the carrier tape.

A main idea of the invention can be found in the fact that the cassette tape feeder further comprises a set of carrier tape and cover tape guides and in a place where can be installed one carrier tape and cover tape guide can be mounted other carrier tape and cover tape guides, each of which is one among the carrier tape and cover tape guides of the set and is selected to the dimensions of the carrier tape and cover tape, on which the SMD electronic components are placed and fed, however each of the carrier tape guides has the same installation component with dimensions adapted to the dimensions of the socket on the body and is replaceably mounted to the body of the cassette tape feeder and comprises a strip guiding the carrier tape with longitudinal side protrusions, which are located in parallel to each other and spaced from each other no less that the carrier tape and cover tape width. To provide good guidance of the carrier tape within the area of one strip end there is a pivotally attached flap of the carrier tape guide, pressed to the strip of the carrier tape guide by a spring. Furthermore, the design of the feeder, the microprocessor controller supervising correct operation of the feeder and the drivers are adapted to all types of carrier tapes and in order to adapt the feeder to another tape type it is only necessary to replace the cover tape and carrier tape guide.

The flap of the guide within the area of the free end may have a hole to allow access to the SMD electronic components located on the carrier tape, downstream which, seeing from the flap free end side, there is a transversal gap located perpendicularly to the longitudinal side protrusions of the guiding strip, through which the cover tape is pulled out.

It is preferred that at the bottom of the body of the cassette tape feeder, under the carrier tape guide, a linear slide bearing made of a flat bar is mounted and seated on a linear guide fixed to a housing of assembly automaton.

Preferably, at the front of the body of the cassette tape feeder, there is a snap mechanism with a snap fastener with recess, which width is no less than the thickness of the crosspiece, with which the snap fastener engages after seating the cassette tape feeder in the linear guide fixed to the housing of the assembly automaton.

An optical sensor can be attached to the body of the cassette tape feeder, to send electric signals specifying the distance of displacement of the carrier tape. The optical sensor increases the accuracy of picking up of electronic components, regardless of their size.

At the front of the body of the cassette tape feeder, there can be a plug of an industrial connector connectable to the industrial connector socket transmitting and receiving electric signals from/to the optical sensor, the carrier tape displacement drive and cover tape pull out drive. The plug of the industrial connector provides a good connection with a microprocessor controller with programmable memory. In another embodiment, the plug of the industrial connector may be replaced by a socket, and then a bunch of electrical wires running to the microprocessor controller has the plug of the industrial connector.

The feeder is equipped with technical solutions that improve precision and reliability of tape displacement without the risk of losing components remaining in the open pockets of the carrier tape. This is possible because of the application of the tape drive and the drive pulling out the cover tape keeping the components in non-open pockets in the form of two independently controlled stepping motors. Control is executed with a microprocessor controller supervising correct operation of the feeder. Driving mechanisms do not generate adverse vibrations during feeder operation. The carrier tape is driven using the stepping motor with a toothed gear and a toothed wheel displacing the tape. An optical sensor of angular position is built-in in the feeder controller to measure angular position of the wheel displacing
the tape. This allows precise displacement of the carrier tape by any stroke depending on the tape type and distances between the pockets for components. The controller reads the tape positions against a set position and supervises so that the tape does not move in an uncontrolled way during operation of the machine.

Pulling out the cover tape covering the components on the carrier tape driving mechanism with a reel for reeling the cover tape is executed by an independently controlled stepping motor with a toothed gear and the reel reeling the used tape. Such solution allows, in precise and fully controlled way, pulling out the used cover tape without the need to apply any mechanical coupling with the motor of the carrier tape drive. The feeder controller controls the force used to pull out the protecting screen or cover tape, which fact guarantees reliable pulling out of used cover tape. This solution allowed complete elimination of a clutch, by which the machine operator controlled the tape pulling out force. The pulling out force is automatically adjusted by the controller, without the need of operator's intervention into the feeder operation, which fact guarantees immediate adaptation of any tape with SMD components on the reel, regardless of tape quality.

The designs of the feeder, the controller and drives are adapted to all types of carrier tapes with SMD electronic components. The feeder is designed to allow the user to adapt to any type of a carrier tape - any pitch, heights and widths. As a standard, the feeder is adapted to the tape of width 8 mm and any pitch. In case of adapting the feeder to other tape type, it is only necessary to replace the tape guiding assembly with the pressure flap. Such solution reduces the costs of operation of the assembly automaton, because when it is necessary to change the type of the carrier tape with components, there is no need to purchase additional feeders specially adapted to the tape types. The feeder has built-in microprocessor controller with programmable memory. The feeder can be programmed in any way by entering data describing electronic components positioned by the feeder. Data entered during feeder programming include: information about component, for example name, type, geometric dimensions, information about the carrier tape type, for example spaces between the pockets with electronic components, width of the carrier tape and information about coordinates for collecting components in relation to the feeder reference point. This data can also be imported from the component databases already entered, representing the components library. The controller comprises the option of digital communication with automatons via an industrial connector. This allows sending programmed information about the component to the feeder. Information concerning the feeder position in the machine sockets is also red by the controller and then sent to the automaton controller. The component displacement release in the feeder in performed by sending control commands to the controller by the machine.

In the presented solution, a mechanism of snap fastener type locking the feeder is employed, which blocks it against sliding out from the automaton during its operation. To place the feeder in the machine, it must be slid into the linear guide until being snapped by the mechanism. The feeder is precisely located in the machine by means of the linear slide bearing fixed to the feeder body. Carrier tapes with electronic components are installed in the feeder in the form of reeled reels. Reels with components are installed in the rear part of the feeder by placing on an axle adapted for that purpose. Due to the pressure component, the tape is secured against spontaneous unreeling.

The subject of the invention is presented in the embodiments in the drawings, of which Fig. 1 presents an axonometric view of a cassette tape feeder, Fig. 2 presents a side view of a front part of the cassette tape feeder, Fig. 3 presents an axonometric view of a front part of a tape guide assembly with a carrier tape drive, Fig. 4 presents an axonometric view of linear guides for the cassette tape feeders in assembly automatons or semi-automatons using SMT technology, Fig. 5 presents a side view of the cassette tape feeder with a carrier tape and a cover tape, and Fig. 6 presents schematically an electrical diagram of the cassette tape feeder.

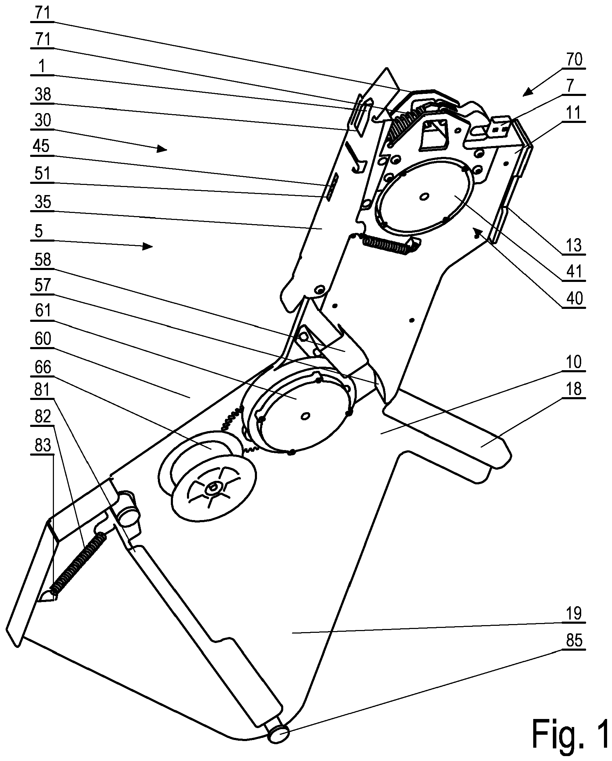

A cassette tape feeder 5 for positioning SMD electronic components placed on a carrier tape 50 with holes 51 and covered with a flap is presented in Figs. 1, 2, 3, 4 and 5. The said cassette tape feeder 5 comprises a body 10, a drive mechanism 40 for the carrier tape 50 displacement with a toothed wheel 45 engaging with the holes 51 of the carrier tape 50 and rotationally seated on the body 10, a driving mechanism 60 for pulling out a cover tape 55 with a reel 66 for collecting the cover tape 55, a wheel, a roll or a reel 80 of the carrier tape 50 and the cover tape 55 rotationally seated on the body 10 and a guide 30 of the carrier tape 50 and the cover tape 55 located over the toothed wheel 45 of the driving mechanism 40 for the carrier tape 50 displacement engaging with the holes 51 of the carrier tape 50.

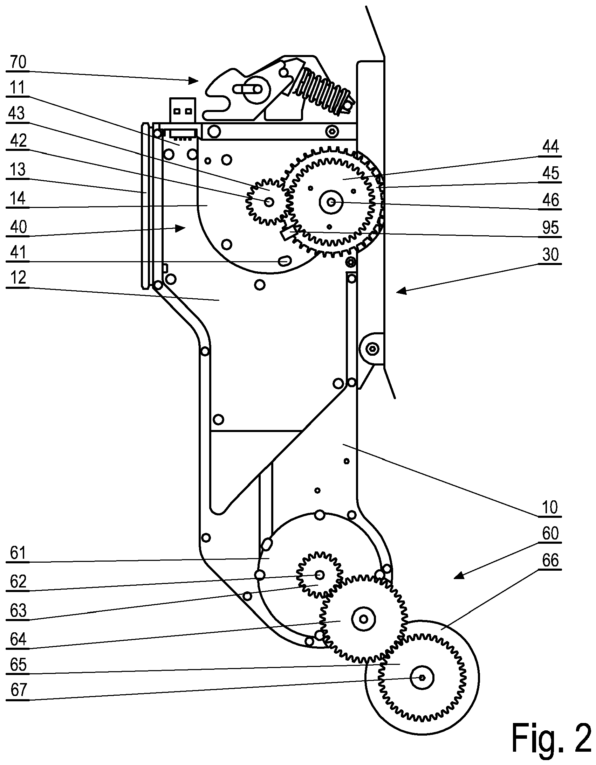

The body 10 is made of a metal sheet, which is bent on edges in numerous places to make the body rigid and invulnerable to twisting and bending. Within the area 11, where the driving mechanism 40 for the carrier tape 50 displacement with the toothed wheel 45 is located, the body 10 is reinforced with a welt 12 made of a metal sheet and fixed to the body 10. At the bottom of the body 10, there is a linear slide bearing 13, assuming that the body 10 bottom is the side located opposite to the side along which the guide 30 of the carrier tape 50 and the cover tape 55, is installed, which is one from a set of the guides 30, 130 of the carrier tape and the flap and which is selected according to the dimensions of the cover tape 55 and carrier tape 50 on which the SMD electronic components are currently being fed. The linear slide bearing 13 is made of a flat bar, which is fixed parallelly to the body 10 with its longitudinal axis of symmetry, and its both longer sides are free, which allows sliding in and displacing linear slide bearing 13 in relation to the linear guide 20 or bed fixed to the housing of the assembly automaton and semi-automaton using the SMT technology. The linear guide 20 has edges bent inwards and in cross-section it is of the letter "C" shape, which provides reliable positioning and seating of the linear slide bearing 13 together with the body 10 in the linear guide 20. Between the slide bearing 13 and the guide 30, welts 14 are fixed to the sides of the body 10, being reinforcements of the body 10. The driving mechanism 40 for displacement of the carrier tape 50 is fixed to the body 10 and the welt 14. The drive mechanism 40, shown in detail in Fig. 2, comprises a stepping or stepper motor 41 with a toothed drive wheel 43 seated on its shaft, an idle pulley or an intermediate pulley 44, meshing with a toothed drive wheel 43 and a toothed wheel 45 rotationally seated on an intermediate shaft 46 together with the idle pulley 44 and fixedly coupled with it. The toothed wheel 45 is of diameter as well as pitch and height of a teeth that meshes within the holes 51 of the carrier tape 50. In particular, the radius of a circle on which teeth notches of the toothed wheel 45 are located is equal to the distance from the axis of rotation of the toothed wheel to the carrier tape 50. An optical sensor 95 of the carrier tape 50 displacement drive 40 and of the cover tape 55 pull out drive 60 is attached to the body 10 of the cassette tape feeder 5.

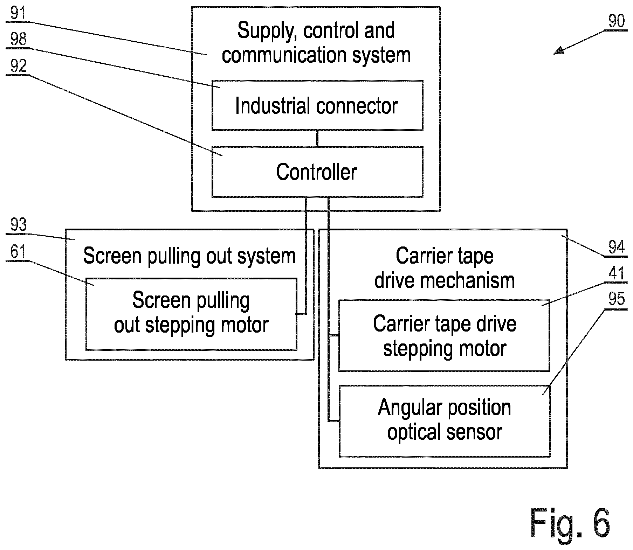

At the front of the body 10, using two flat supports 71, a snap mechanism 70 is installed, assuming that the front of the body 10 is that part of the body 10, in particular side of the body 10, which is faced to the front to a housing 4 of the assembly automaton or semi-automaton using the SMT technology, and which is located at the angle in relation to the direction of the body 10 displacement in the guide 20 cooperating with the linear slide bearing 13. Between the flat supports 71, spaced from each other by a few centimetres, there is a snap component 72 installed pivotally, operating as a two-way lever, wherein one end of the lever has a recess 73 into which a crosspiece 6 engages that is fixed to the automaton housing, and wherein the other side of the lever has a thrust component 74, which is affected by a spring 75 seated with its other end on a strut 76 installed between flat supports 71. The snap component 72 encloses the crosspiece 6 from three sides and is pressed to the crosspiece 6 using the spring 75. Below the snap component 72, a plug 7 of an industrial connector 98, shown in Fig. 6, is installed to the body 10, which after installing the cassette tape feeder 5 for positioning electronic components in the assembly automaton or semi-automaton is seated in a socket 8 of the industrial connector 98 fixed to the body or the housing 4 of the assembly automaton or semi-automaton using the SMT technology.

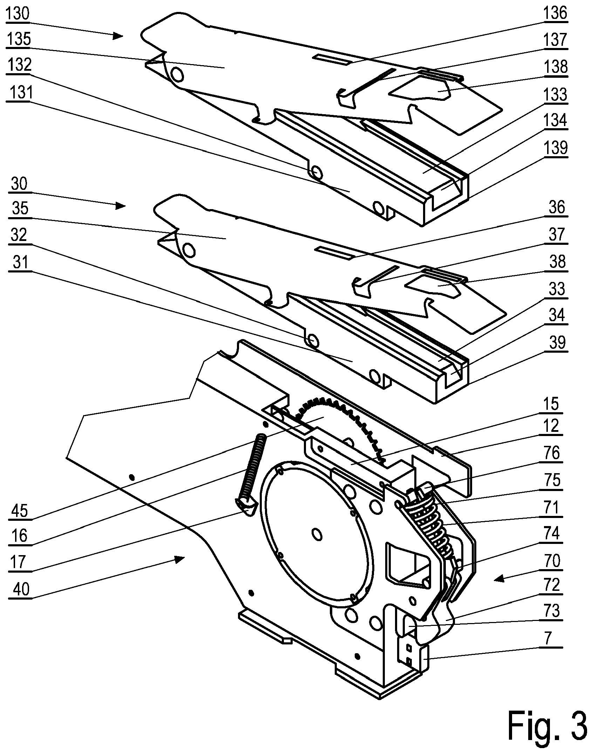

The guide 30 or 130 of the carrier tape 50 and the cover top 55 is located over the toothed wheel 45, as shown in Fig. 3, and is replaceably mounted with its installation component 31 or 131 using screws 32 or 132 to a longitudinal seat or socket 15 of the body 10. The guide 30 or 130 has longitudinal recess 33 or 133 in the strip 39 or 139 of the guide 30 or 130 running along the whole length of the guide 30 or 130. Protruding longitudinal side protrusions or edges of the strip 39 or 139 facilitate guiding the carrier tape 50 and the cover tape 55 along the guide 30 or 130, wherein the recess 33 or 133 has chamfer 34 or 134 at its end. Longitudinal side protrusions of the guide 30 or 130 are located parallel to each other and are spaced from each other no less than the width of the carrier tape 50 and the cover tape 55, which allows displacement of the carrier tape 50 and the cover tape 55 along the guide 30 or 130. At the end of the strip 39 or 139 of the guide 30 or 130, where the carrier tape 50 and the cover tape 55 are introduced, there is a flap 35 or 135 of the guide 30 or 130, installed pivotally, which with its bent sides encompasses the guide 30 or 130. The flap 35 or 135 of the guide 30 or 130 is pulled by a spring 16, which is connected with one end to the protruding grip of the flap 35 or 135, and with the other to a catch 17 located on the body 10. The middle part of the flap 35 or 135 of the guide 30 or 135, which is located over the longitudinal recess 33 or 133 of the guide 30 or 130, starting from the pivotal fixing of the guide shield, has a longitudinal hole 36 or 136 located in parallel to the longitudinal recess 33 or 133, in which the carrier tape 50 and the cover tape 55 displace, and the longer axis of symmetry of the longitudinal hole 36 or 136 is parallel to the displacement direction of the carrier tape 50 and cover tape 55. The flap 35 or 135 of the guide 30 or 130 also has transversal hole 37 or 137, through which the cover tape 55 is pulled out and on the edge of which the cover tape 55 is separated from the carrier tape 50 to allow the access to the electronic components. Additionally, the flap 35 of the guide 30 has a hole 38 or 138, for example in the shape of rectangle, which allows picking up the electronic components located on the carrier tape 50 deprived of the cover tape 55. From the Fig. 3 it results that the previously mentioned holes of any guide are arranged according to the direction of the carrier tape displacement, thus the first hole is the longitudinal hole 36 or 136, the next hole is the gap or the transversal hole 37 or 137, through which the cover tape is pulled out and the last hole is the hole 38 or 138, through which a suction nozzle is inserted into to pick up the electronic components. The transversal hole 37 or 137 and the hole 38 or 138 that allows picking up the electronic components, alike the width and depth of the recess 33 or 133 in any of the guides are adapted to the width of the carrier tape 50 and the cover tape 55 as well as the size of electronic components, thus each of the guides 30 or 130 together with the flap 35 or 135 of the guide is replaceable and is one among the set of guides 30 or 130 with the flap of the guide, which is fixed to the body 10 of the cassette tape feeder 5, before the body 10 is inserted into the linear guide 20 cooperating with the linear sidle bearing 13. In order to allow replacement of the guide 30, being one of the guides, to the other guide, for example 130, which is also one of the guides, each of the guides 30, 130 of the carrier tape has the same installation component 31, 131 of dimensions adapted to the dimensions of the socket 15 located in the body 10 of the cassette tape feeder 5.

Pulling out the cover tape 55, after its separation from the carrier tape 50, is executed by the drive mechanism 60 for pulling out the cover tape 55 with the reel 66 for reeling the cover tape 55, presented in details in Figs. 1, 2 and 5, which is fixed to the body 10. The drive mechanism 60 for pulling out the cover tape 55 with the reel 66 for collecting the cover tape 55 comprises a stepping motor 61 with a drive shaft 62, on which a drive toothed wheel 63 is mounted. The drive toothed wheel 63 meshes with an idle pulley 64, which in turn meshes with a main toothed wheel 65 seated on a shaft 67, on which the reel 66 or the roll is seated for reeling the cover tape 55. The drive toothed wheel 63, the idle pulley 64 and the main toothed wheel 65 form a toothed gear of the drive mechanism 60 for pulling out the cover tape 55. Both the main toothed wheel 65 and the reel 66 or the roll for reeling the cover tape 55 are fixedly seated in relation to each other on the main shaft 67, thus the motor 61 torque is transmitted to the reel 66 or the roll for collecting the cover tape 55. Tensioning of the cover tape 55 is adjusted depending on the magnitude of torque required to rotate the reel 66 or the roll for reeling the cover tape 55. If the cover tape 55 is separated from the carrier tape 50, its tensioning decreases, alike the torque necessary to put the reel 66 or the roll collecting the cover tape 55 into rotational motion, which is the signal to put the reel 66 or the roll for reeling the cover tape 55 into rotational motion. At the moment the torque necessary to put the reel 66 or the roll for collecting the cover tape 55 into rotational motion increases above the upper threshold, the motor 61 is turned off.

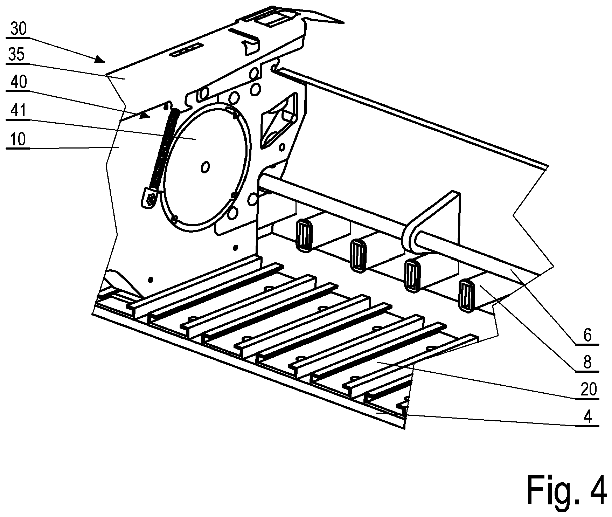

Fig. 4 presents in details the set of linear guides 20 in the shape of beds fixed one by the other to the body or the housing 4 of the assembly automaton or semi-automaton using the SMT technology. In one of the beds, the body 10 of the cassette tape feeder 5 is seated, which is shown only partially, and which snap fastener is engaged by the crosspiece and has an inlet for selecting directed downwards. The snap fastener is kept with its inlet downwards using a depressing spring and it is released by using proper force acting on the grip 18 of the body 10. Near each of the linear guides 20, below the crosspiece 6, by which the snap fasteners of the cassette tape feeders 5 engage, there is the socket 8 of the industrial connector 98. To the previously shown fragment of the body 10 with visible motor 41 for displacement of the carrier tape 50 and the cover tape 55, there is the replaceable guide 30 with the flap 35 fixed.

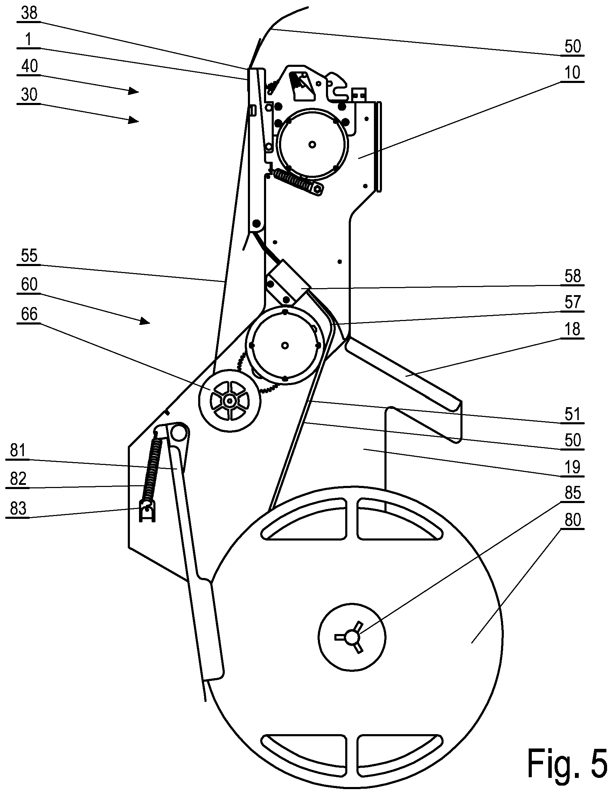

Fig. 5 presents a side view of the cassette tape feeder 5, on the body of which, there is a roll 80 or a reel rotationally seated for example on a slide bearing 85, on which the carrier tape 50 with cover tape 55 is reeled. The roll 80 or the reel is seated on a rear fragment 19 of the body 10. Near the roll 80 or the reel, there is a pressure strip 81 of the roll 80 or the reel with the carrier tape 50 and the cover tape 55 installed pivotally, which presses the roll 80 or the reel to the slide bearing 85 preventing spontaneous unreeling of the carrier tape 50 and the cover tape 55. The pressure strip 81 of the roll 80 or the reel is pressed to the roll 80 or the reel rim using the spring 82 engaged with one end to a narrower arm of the strip 81 of the roll 80 or the reel and with the other end with the snap 83 located on the body 10.

As presented in Fig. 5, the carrier tape 50 and the cover tape 55 are led from the roll 80 or the reel to a first guide 57 of the tape and to a second guide 58 of the tape, which cause that the carrier tape 50 and the cover tape 55 by-pass the drive mechanism 60 for pulling out the cover tape 55, which is located between the roll 80 or the reel and the drive mechanism 40 displacing of the carrier tape 50. The carrier tape 50 with the cover tape 55 from the second guide 58 is directed to the guide 30 with the flap 35 having a transversal hole 37, on the edge of which the cover tape 55 is separated from the carrier tape 50. After separation of the cover tape 55, the cover tape 55 is directed to the reel 66 reeling the used cover tape 55, and the carrier tape 50 is guided along the recess 33 in the guide 30 and transferred so far, that the next electronic component 1, positioned on the carrier tape 50, is available through the hole 38 for the head terminated with suction nozzle (not shown), picking up the electronic component 1. Used carrier tape 50 without electronic components is directed to the reel (not shown) for the used carrier tape 50, on which the used carrier tape 50 is reeled.

Fig. 6 schematically presents an electronic system 90, comprising a main supply system 91, control and communication with a controller 92 and an electric system 93 for pulling out the cover tape 55 with the stepper motor 61 for pulling out the cover tape 55 and an electric system 94 of the carrier tape 50 and cover tape 55 drive with the stepping motor 41 of the carrier tape 50 and cover tape 55 drive and the optical sensor 95 of angular positioning of a toothed wheel of the carrier tape 50 and the cover tape 55. The electric system 93 for pulling out the cover tape 55 and the electric system 94 of the carrier tape 50 and cover tape 55 drive are connected with the supply system 91 via the industrial connector 98.

The cassette tape feeder presented in Fig. 1, as mentioned previously, is used to position the SMD electronic components located on the tapes. The carrier tape with the cover tape is reeled on rolls or reels installed in the rear part of the feeder on the tape installing axle. To secure the tape from spontaneous unreeling, the tape pressure strip is applied. Pressure of the bearing strip is provided by the pressure spring. The tape is threaded through the tape guides to the replaceable assembly of the tape guide, comprising the tape guiding strip, tape guide flap and the flap pressure spring, providing optimum pressure on the tape. The strip guiding the tape has holes adapted to install the feeder body, and the width of the strip depends on the tape standard. In one of the solutions presented in particular in Fig. 3, the guide flap, as mentioned before, has a series of holes adapted to displace the tape through the toothed wheel, to pull out the tape cover tape and to pick up SMD components from the tape using a suction nozzle of the head. Because of application of the replaceable guide assembly, one feeder can be adapted to operate with any tape standard. Precise and reliable displacement of the tape is provided by the drive mechanism of the carrier tape and the cover tape, comprising the stepping motor that, using the toothed wheel, transfers the torque to the second toothed wheel, which is fixedly coupled with the tape displacement toothed wheel, given in details in Fig. 2. To accurately measure the angular position of the tape displacement wheel, the optical sensor of the angular position is provided, which gives the option to control and adjust the tape displacement. The cover tape protecting the components located on the carrier tape is pulled out from the carrier tape through the cover tape hole. The cover tape is stored on the reel reeling the used cover tape, which is shown in particular in Fig. 1. To provide reliable pulling out of the cover tape, a pulling out drive mechanism is introduced, which by the toothed gear with toothed wheels transfers the torque to the reeling reel, shown in details in Figs. 1 and 2. Application of a separate drive allowed to avoid the coupling of the drive mechanism for pulling out the tape with the drive mechanism of the carrier tape and cover tape and allowed continuous smooth control of the cover tape tensioning force. Displacement of the carrier tape and pulling out of the cover tape is supervised by the controller located in the feeder body. The controller controls the drive mechanism of carrier tape, providing precise displacement of the carrier tape and the option to adapt the pitch to the proper tape standard. Because of application of the optical sensor for angular position of the toothed wheel, more precision and reliability of the process is provided. The pull out drive of the cover tape securing the components located on the carrier tape is also controlled by the controller. The feeder controller communicates with the positioning automaton via the industrial connector. Because of separating the function between two independent stepping motors, more precise operation of the feeder and elimination of problematic clutches adjusting the pull out of the cover tape from SMD components is provided. After placing the carrier tape and the cover tape on the feeder body, the cassette tape feeder is placed in the machine component storage. In one of the solutions given in Fig. 1, the feeder has the linear slide bearing installed to the body, which slides into the linear guide. The linear guides are installed in the device components storage to the base of the storage, as particularly shown on Fig. 4. Because of application of the snap mechanism, the feeder is locked in the device using a simple method. When sliding in the cassette feeder, the snap component directed by the linear guide contacts the crosspiece, which causes the change of the position of the component from open to closed, in which the component encompasses the crosspiece precluding accidental sliding out of the feeder. Spontaneous opening of the mechanism is locked by the pressure of the snap fastener using a spring. In case of sliding out the cassette tape feeder, it is necessary to use force exceeding the force of the spring pressure, which releases the snap mechanism.

Feature distinguishing the cassette tape feeder for positioning SMD electronic components in comparison to known solutions is the improvement of precision and reliability of tape displacement by separating the process of tape displacement from pulling out the cover tape covering the SMD components, using two independent drives. The controller controlling the feeder operation provides the option to smoothly control the tape displacement by a controlled pitch and determines the cover tape pulling out force. Additionally, because of application of the replaceable assembly for guiding the tape, it is possible to use many tape standards.

The solution according to the invention is presented in relation to selected embodiments. These embodiments do not limit the invention. It is obvious that modifications can be introduced without deviating from the nature of the solution. The presented embodiments do not exhaust all applications of the solution according to the invention.

## Claims

1. A cassette tape feeder (5) for positioning SMD electronic elements placed on a carrier tape (50) with holes (51) and covered with a cover tape (55) and comprising a body (10), provided in combination with a set of carrier tape and cover tape guides (30,130), a drive (40) for feeding the carrier tape using a toothed wheel (45) engaging with the holes (51) of the carrier tape (50) and seated on the body (10), a drive (60) for removing the cover tape using a reel (66) for collecting the cover tape, a carrier tape and cover tape reel (80) rotationally seated on the body (10) and a carrier tape and cover tape guide (30, 130) comprising a strip (39, 139) guiding the carrier tape (50), a longitudinal recess (33, 133) in the strip (39, 139) running along the whole length of the guide (30, 130) and protruding longitudinal side protrusion of the strip (39, 139) facilitate guiding the carrier tape (50) with the cover tape (55), whereby a width and a depth of the recess (33, 133) are adapted to a width of the carrier tape (50) and the cover tape (55) as well as a size of the electronic elements, while, within an area of one strip (39, 139) end, there is a pivotally attached flap (35, 135) of the carrier tape guide (30, 130) pressed to the strip (39, 139) of the carrier tape guide (30, 130) by means of a spring (16) and located above the toothed wheel (45) of the drive (40) for displacement of the carrier tape engaging with the holes of the carrier tape, **characterized in that** the carrier tape and cover tape guide (30, 130) mounted to the body (10) is one among the carrier tape and cover tape guides (30, 130) of the set and is selected to dimensions of the cover tape and carrier tape, on which the SMD electronic components (1) are placed and fed, while each of the carrier tape guides (30, 130) has the same installation component (31, 131) with dimensions adapted to the dimensions of a socket (15) on the body (10) to allow replacement of the guide (30), being one of the guides (30, 130), to the other guide (130) being also one of the guides (30, 130), and is replaceably mounted to the body (10) of the cassette tape feeder (5), and the design of the feeder, the microprocessor controller supervising correct operation of the feeder and the drivers are adapted to all types of carrier tapes and in order to adapt the feeder to another tape type it is only necessary to replace the cover tape and carrier tape guide.

2. The cassette tape feeder according to claim 1, **characterized in that** the flap (35, 135) of the guide (30, 130) within an area of free end has a hole (38, 138) to allow access to the SMD electronic components (1) located on the carrier tape (50), downstream which, seeing from the flap (35, 135) free end side, there is a transversal gap (37, 137) located perpendicularly to the longitudinal side protrusions of the guiding strip (39, 139), through which the cover tape (55) is pulled out.

3. The cassette tape feeder according to claim 1 or 2, **characterized in that** at the bottom of the body (10) of the cassette tape feeder (5), under the carrier tape (50) guide (30, 130), a linear slide bearing (13) made of a flat bar is mounted and seated on a linear guide (20) fixed to a housing of assembly automaton.

4. The cassette tape feeder according to claim 1 or 2 or 3, **characterized in that** at the front of the body (10) of the cassette tape feeder (5), there is a snap mechanism (70) with a snap fastener (72) with recess (73), whereby a width of the recess (73) is no less than a thickness of a crosspiece (6), with which the snap fastener (72) engages after seating the cassette tape feeder (5) in the linear guide (20) fixed to the housing of the assembly automaton.

5. The cassette tape feeder according to claim 1 or 2 or 3, **characterized in that** an optical sensor (95) sending electric signals specifying the distance of the carrier tape (50) displacement is installed to the body (10) of the cassette tape feeder (5).

6. The cassette tape feeder according to claim 5, **characterized in that** at the front of the body (10) of the cassette tape feeder (5), there is a plug (7) of an industrial connector (98) connectable to the industrial connector (98) socket (8) transmitting and receiving electric signals from/to the optical sensor (95), the carrier tape (50) displacement drive (40) and the cover tape (55) pull out drive (60).

7. The cassette tape feeder according to claim 1 or 2 or 3 or 4 or 5 or 6, **characterized in that** the cover tape (55) pull out drive mechanism (60) with the reel (66) for collecting the cover tape (55) comprises a stepper motor (61) driving the reel (66) for collecting the cover tape (55) via the toothed gear.

## Patentansprüche

1. Eine Kassettenbandzuführung (5) zur Positionierung von elektronischer SMD-Elemente, welche auf einem Tragband (50) mit Öffnungen (51) angeordnet und mit einer Abdeckung (55) überdeckt sind, umfassend einen mit einem Satz von Führungen (30, 130) des Tragbandes und der Abdeckung ausgestatteten Körper (10), einen Antrieb (40) für die Verschiebung des Tragbandes mit einem Zahnrad (45), welches sich mit den Öffnungen (51) des Tragbandes (50) verzahnt und auf dem Körper (10) gelagert ist, einen Antrieb (60) für das Abziehen der Abdeckung mit einem Rad (66) zum Aufwickeln der Abdeckung, ein auf dem Körper (10) drehbar gelagertes Rad (80) des Tragbandes und der Abdeckung sowie die Führung (30, 130) des Tragbandes und der Abdeckung, wobei die Führung (30, 130) oberhalb des Zahnrades (45) des Antriebs (40) für die Verschiebung des Tragbandes angeordnet ist, wobei die Führung (30, 130) eine das Tragband (50) führende Leiste (39, 139), eine längliche, entlang der ganzen Länge der Führung (30, 130) verlaufende Eintiefung (33, 133) in der Leiste (39, 139) sowie längliche, seitlich hervorstehende Vorsprünge aufweist, welche das Führen des Tragbandes (50) mit der Abdeckung (55) erleichtern, wobei die Breite und die Tiefe der Eintiefung (33, 133) an die Breite des Tragbandes (50) und der Abdeckung (55) sowie an die Ausmaße von elektronischen Elementen angepasst sind, wobei im Bereich eines Endes der Leiste (39, 139) eine Klappe (35, 135) der Führung (30, 130) des Tragbandes schwenkbar oberhalb des Zahnrades (45) des Antriebs (40) für die Verschiebung des Tragbandes befestigt ist, wobei die Klappe (35, 135) mittels einer Feder (16) an die Leiste (39, 139) der Führung (30, 130) des Tragbandes (50) gedrückt wird, **dadurch gekennzeichnet, dass** die am Körper (10) befestigte Führung (30, 130) des Tragbandes und der Abdeckung zu dem Satz von Führungen (30, 130) des Tragbandes und der Abdeckung gehört und an die Ausmasse der Abdeckung und des Tragbandes angepasst ist, auf welchem die momentan zuzuführenden elektronischen SMD-Elemente (1) angeordnet sind, wobei jede der Führungen (30, 130) des Tragbandes ein gleiches Montageteil (31, 131) aufweist, dessen Ausmasse an die Ausmasse eines an dem Körper (10) angeordneten Sitzes (15) angepasst sind zwecks Austausches der Führung (30) - welche eine der Führungen (30, 130) ist - gegen eine andere Führung (130), welche eine der Führungen (30, 130) ist, wobei jede der Führungen (30, 130) am Körper (10) der Kassettenbandzuführung (5) austauschbar befestigt ist, wobei die Form der Zuführvorrichtung, der die korrekte Arbeitsweise der Zuführvorrichtung überwachende Mikroprozessor und Steuereinheiten und Antriebe an alle Typen von Zuführvorrichtungen angepasst sind, wobei zwecks Anpassung der Zuführvorrichtung an eine andere Bandsorte lediglich die Bandabdeckung und die Führung des Tragbandes ausgetauscht werden sollen.

2. Die Kassettenbandzuführung nach Anspruch 1 **dadurch gekennzeichnet, dass** die Klappe (35, 135) der Führung (30, 130) im Bereich ihres freien Endes eine Öffnung (38, 138) aufweist, welche den Zugang zu den elektronischen, an dem Tragband (50) angeordneten SMD-Elementen (1) ermöglicht, hinter welcher - von dem freien Ende der Klappe (35, 135) her gesehen - sich ein Querspalt (37, 137) befindet, welcher senkrecht zu den länglichen, seitlichen Vorsprüngen der führenden Leiste (39, 139) angeordnet ist, wobei mit dem Querspalt (37, 137) die Abdeckung (55) abgezogen wird.

3. Die Kassettenbandzuführung nach Anspruch 1 oder 2 **dadurch gekennzeichnet, dass** an der Unterseite des Körpers (10) der Kassettenbandzuführung (5) unterhalb der Führung (30, 130) des Tragbandes (50) ein lineares Gleitlager (13) angeordnet ist, das aus einer Flachleiste gefertigt und in einer am Automatenkörper fixierten Linearführung (20) lagerbar ist.

4. Die Kassettenbandzuführung nach Anspruch 1 oder 2 oder 3 **dadurch gekennzeichnet, dass** an der Vorderseite des Körpers (10) der Kassettenbandzuführung (5) ein Schnappmechanismus (70) mit einem eine Aussparung (73) aufweisenden Schnappverschluss (72) angeordnet ist, wobei die Breite der Aussparung (73) nicht kleiner als die Dicke des Querstabes (6) ist, mit welchem der Schnappverschluss (72) nach dem Einsetzen der Kassettenbandzuführung (5) in der am Automatenkörper fixierten Linearführung (20) gekoppelt wird.

5. Die Kassettenbandzuführung nach Anspruch 1 oder 2 oder 3 **dadurch gekennzeichnet, dass** am Körper (10) der Kassettenbandzuführung (5) ein optischer Sensor (95) befestigt ist, der elektrische Signale sendet, welche die Verschiebungsgröße des Tragbandes (50) angeben.

6. Die Kassettenbandzuführung nach Anspruch 5, **dadurch gekennzeichnet, dass** an der Vorderseite des Körpers (10) der Kassettenbandzuführung (5) ein Stecker (7) eines Industriesteckverbinders (98) angeordnet ist, wobei der Stecker (7) an eine Steckbuchse (8) des Industriesteckverbinders (98) anschliessbar ist, der elektrische Signale zu/von dem optischen Sensor (95), dem Antrieb (40) für die Verschiebung des Tragbandes(50) und dem Antrieb (60) für das Abziehen der Abdeckung (55) sendet und empfängt.

7. Die Kassettenbandzuführung nach Anspruch 1 oder 2 oder 3 oder 4 oder 5 oder 6, **dadurch gekennzeichnet, dass** der Antriebmechanismus (60) für das Abziehen der Abdeckung (55) mit dem Rad (66) zum Aufwickelnder Abdeckung (55) einen Schrittmotor (61) umfasst, mit welchem das Rad (66) zum Aufwickelnder Abdeckung (55) über ein Zahnradgetriebe angetrieben wird.

## Revendications

1. Un dispositif d'alimentation de bande de cassette (5) pour le positionnement des éléments électroniques SMD placés sur une bande porteuse (50) avec des ouvertures (51) et couverts d'une couverture de protection (55) contenant un corpus (10) équipé d'un ensemble de glissières (30, 130) d'une bande porteuse et d'un capot protecteur, d'une transmission (40) du déplacement de la bande porteuse avec une roue dentée (45) s'endentant avec les ouvertures (51) de la bande transporteuse (50) et monté sur le corpus (10), de la transmission du hauban (60) du capot protecteur avec la roue (66) pour enrouler le capot protecteur, la roue (80) de la bande porteuse et les protections montées de façon rotative sur le corpus (10) et la glissière (30, 130) de la bande porteuse et de la protection située au-dessus de la roue dentée (45) de la transmission (40) du déplacement de la bande porteuse s'endentant avec les ouvertures de la bande porteuse et contenant une coulisse (39, 139) guidant la bande porteuse (50), un enfoncement longitudinal (33, 133) dans la coulisse (39, 139) situé le long de la longueur de la glissière (30, 130) et des rebords longitudinaux latéraux surplombants facilitant le guidage de la bande porteuse (50) avec la protection (55), toutefois la largeur et la profondeur de l'enfoncement (33, 133) sont adaptées à la largeur de la bande porteuse (50) et de la protection (55) ainsi qu'à la dimension des éléments électroniques, toutefois du côté d'un bord de la coulisse (39, 139) est fixé de façon oscillante le clapet (35, 135) de la glissière (30, 130) de la bande porteuse appuyé contre la coulisse (39, 139) de la glissière (30, 130) de la bande porteuse (50) à l'aide d'un ressort (16), **caractérisé en ce que** la glissière (30, 130) de la bande porteuse et de la protection fixée au corpus (10) est une des glissières (30, 130) de la bande porteuse et de la protection de l'ensemble et choisie par rapport aux dimensions de la bande porteuse et de la protection sur laquelle sont placés les éléments électroniques SDM (1) actuellement donnés, toutefois chacune des glissières (30, 130) de la bande porteuse possède le même élément de montage (31, 131) aux dimensions adaptées à la dimension de la prise (15) se trouvant sur le corpus (10) dans le but de changer la glissière (30) étant une des glissières (30, 130) pour une autre glissière (130) étant une des glissières (30,130), et chacune des glissières (30, 130) est fixée de façon échangeable au corpus (10) du dispositif d'alimentation de bande de cassette (5), et la forme du dispositif, le microprocesseur surveillant le fonctionnement correct de la bande et à adapter le dispositif à un autre type de bande il faut seulement changer la protection de la bande et la glissière de la bande porteuse.

2. Le dispositif d'alimentation de bande de cassette selon la revendication 1 **caractérisé en ce que** le clapet (35, 135) de la glissière (30, 130) du côté de la fin libre possède une ouverture (38, 138) permettant l'accès aux éléments électroniques SMD (1) placés sur la bande porteuse (50) derrière lequel, en regardant à partir de la fin libre du clapet (35, 135) se trouve une fente transversale (37, 137) située parallèlement aux rebords longitudinaux latéraux de la coulisse guidant (39, 139) par laquelle est tirée la protection (55).

3. Le dispositif d'alimentation de bande de cassette selon la revendication 1 ou 2 **caractérisé en ce que**, en bas du corpus (10) du dispositif d'alimentation de bande de cassette (5) en-dessous de la glissière (30, 130) de la bande porteuse (50) se trouve le pallier linéaire à glissement (13) effectué en fer à plat et placé dans le guidage linéaire (20) fixé au corpus de l'automate.

4. Le dispositif d'alimentation de bande de cassette selon la revendication 1 ou 2 ou 3 **caractérisé en ce que**, à l'avant du corpus (10) du dispositif d'alimentation de bande de cassette (5) se trouve le mécanisme de fermeture (70) avec la fermeture (72) possédant un évidement (73) dont la largeur n'est pas plus petite que l'épaisseur de la barre transversale (6) avec laquelle s'accouple la fermeture (72) après avoir posé le dispositif d'alimentation de bande de cassette (5) dans le guidage linéaire (20) fixé au corpus de l'automate.

5. Le dispositif d'alimentation de bande de cassette selon la revendication 1 ou 2 ou 3 **caractérisé en ce qu'**au corpus (10) du dispositif d'alimentation de bande de cassette (5) est fixé le capteur optique (95) envoyant les signaux électriques définissant la grandeur de la course de la bande porteuse (50).

6. Le dispositif d'alimentation de bande de cassette selon la revendication 5 **caractérisé en ce que** à l'avant du corpus (10) du dispositif d'alimentation de bande de cassette (5) se trouve la fiche (7) du raccord industriel (98) raccordable à la prise (8) du raccord industriel (98) émettant et recevant les signaux électriques au/du capteur optique (95), de la transmission (40) de la course de la bande porteuse (50) et de la transmission du hauban (60) de la protection (55).

7. Le dispositif d'alimentation de bande de cassette selon la revendication 1 ou 2 ou 3 ou 4 ou 5 ou 6 **caractérisé en ce que** le mécanisme de transmission du hauban (60) de la protection (55) avec la roue (66) à enrouler la protection (55) contient un moteur pas à pas (61) propulsant la roue (66) pour enrouler la protection (55) par la transmission par roues dentées.
